# EUROPÄISCHE PATENTSCHRIFT

(11) **EP 3 329 522 B1**
(45) Veröffentlichungstag und Bekanntmachung des Hinweises auf die Patenterteilung: **30.06.2021**
(21) Anmeldenummer: 16744677.2
(22) Anmeldetag: 08.07.2016
(51) Int. Cl.: H01L 41/04, H05H 1/24

(54) **VERFAHREN ZUR FREQUENZREGELUNG EINES PIEZOELEKTRISCHEN TRANSFORMATORS SOWIE SCHALTUNGSANORDNUNG MIT EINEM PIEZOELEKTRISCHEN TRANSFORMATOR**
METHOD FOR FREQUENCY CONTROL OF A PIEZOELECTRIC TRANSFORMER AND SWITCH ARRANGEMENT COMPRISING A PIEZOELECTRIC TRANSFORMER
PROCÉDÉ DE RÉGULATION DE FRÉQUENCE D'UN TRANSFORMATEUR PIÉZOÉLECTRIQUE ET AGENCEMENT DE CIRCUITS POURVU D'UN TRANSFORMATEUR PIÉZOÉLECTRIQUE

(30) Priorität: 29.07.2015 DE 102015112410
(43) Veröffentlichungstag der Anmeldung: 06.06.2018
(60) Teilanmeldung: 18158631.4
(73) Patentinhaber: TDK Electronics AG, 81671 München (DE)
(72) Erfinder: WEILGUNI, Michael, 4232 Hagenberg (AT); PUFF, Markus, 8010 Graz (AT)
(74) Vertreter: Epping - Hermann - Fischer
(86) Internationale Anmeldenummer: PCT/EP2016/066332
(87) Internationale Veröffentlichungsnummer: WO 2017/016853

(56) Entgegenhaltungen:
- DE-A1- 19 918 607
- DE-A1-102004 019 196
- DE-A1-102013 100 617
- JP-A- S61 220 386
- US-A- 5 394 048
- US-A- 6 144 139
- US-B1- 6 348 755

## Beschreibung

Die Erfindung betrifft ein Verfahrens zur Frequenzregelung eines piezoelektrischen Transformators sowie eine Schaltungsanordnung, umfassend einen piezoelektrischen Transformator und eine Wechselspannungsquelle zur Erzeugung einer Eingangsspannung an einer Eingangsseite des piezoelektrischen Transformators.

Piezoelektrische Transformatoren ermöglichen die Umsetzung einer zugeführten elektrischen Wechselspannung als Eingangsspannung an einer Eingangsseite in eine höhere oder niedrigere Wechselspannung als Ausgangsspannung an einer Ausgangsseite eines piezoelektrischen Elementes. Das piezoelektrische Element ist häufig aus einer Blei-Zirkonat-Titanat-Verbindung (PZT) aufgebaut. In Abhängigkeit von einer entsprechenden Polarisation der Eingangs- sowie Ausgangsseite des piezoelektrischen Elementes wird dieses bei Anlegen einer sinusförmigen Wechselspannung an der Eingangsseite aufgrund des inversen piezoelektrischen Effektes z.B. in Dickenrichtung verformt, wodurch eine Schwingung in Längsrichtung des piezoelektrischen Elementes erzeugt wird. Dies wiederum erzeugt an der Ausgangsseite aufgrund des direkten piezoelektrischen Effektes eine entsprechende Ausgangsspannung.

Wenn die Frequenz der angelegten Eingangsspannung mit der Resonanzfrequenz des piezoelektrischen Elementes übereinstimmt, resultiert daraus eine elektromechanische Resonanz des Elementes, so dass die mechanische Vibration ein Maximum erreicht. Auf diese Weise kann an der Ausgangsseite des piezoelektrischen Elementes eine sehr hohe Ausgangsspannung erzeugt werden. Eine Anwendung besteht beispielsweise darin, einen piezoelektrischen Transformator als Plasmagenerator zu betreiben, wobei aufgrund einer hohen Ausgangsspannung an der Ausgangsseite des Plasmagenerators eine Ionisation eines den Plasmagenerator umströmenden Arbeitsgases stattfindet, so dass ein Plasma erzeugt wird.

Beim Betrieb eines piezoelektrischen Transformators ist ferner stets wünschenswert, den Transformator bei einem maximalen Wirkungsgrad zu betreiben. Der maximale Wirkungsgrad kann immer nur bei einer bestimmten Frequenz erreicht werden. Diese Frequenz hängt von zahlreichen Parametern, unter anderem von der Eingangsspannung und der verwendeten Arbeitsumgebung, ab. Für die Auffindung des maximalen Wirkungsgrads ist deshalb Information vom Bauteil erforderlich.

Für die Frequenzregelung herkömmlicher piezoelektrischer Transformatoren existieren bereits mehrere Möglichkeiten. Zum Beispiel kann die Spannung an der Sekundärseite (Ausgangsspannung) betrachtet werden. Eine andere Möglichkeit ist der Einsatz einer zusätzlichen Elektrode am Transformator zur Gewinnung eines Rückkopplungssignals.

Bei der ersten Möglichkeit besteht ein Nachteil darin, dass jeder Abgriff der Ausgangsspannung die Amplitude der Ausgangsspannung und somit das Schwingverhalten des Piezoelementes und schließlich die Funktionsweise des piezoelektrischen Transformators beeinflusst. Insbesondere bei Verwendung des piezoelektrischen Transformators als Plasmagenerator würde eine derartige Möglichkeit der Frequenzregelung die Funktionsweise des Plasmagenerators stark negativ beeinflussen.

Die zweite Variante hat dagegen den Nachteil, dass dadurch eine weitere Kontaktierung des piezoelektrischen Bauteils notwendig wird, welche den Aufbau verkompliziert.

JP S61 220386 A zeigt einen piezoelektrischen Transformator, der mit einer Wechselspannung betrieben wird. Ein Phasenvergleicher vergleicht die Phase der Eingangswechselspannung mit der Phase eines Signals, welches proportional zum Eingangsstrom ist. Dieses Signal wird gewonnen durch eine Umwandlung des Stroms, welcher durch den piezoelektrischen Transformator fließt, in eine zugehörige Spannung. Eine Frequenz der Eingangswechselspannung wird in Abhängigkeit der ermittelten Phasendifferenz so geregelt, dass die Phasen der Eingangswechselspannung des piezoelektrischen Transformators und des Eingangsstroms angeglichen werden.
DE 199 18 607 A1 zeigt eine Ansteuerschaltung für eine Eingangsspannung eines piezokeramischen Umformers.

DE 10 2004 016196 A1 beschreibt eine Vorrichtung zur Durchführung eines Verfahrens zur Verringerung unerwünschter Schwingungsmodi eines elektromechanischen Systems.

DE 10 2013 100617 A1 beschreibt die Verwendung eines piezoelektrischen Transformators zur Erzeugung eines Plasmas.

Weitere Verfahren zur Frequenzregelung sind aus US 5, 394, 048 A, US 6,144,139 A und US 6,348,755 B1 bekannt.

Es besteht daher die Aufgabe, einen piezoelektrischen Transformator, insbesondere einen piezoelektrischen Plasmagenerator, hinsichtlich der Frequenz so zu regeln, dass dieser stets bei maximalem Wirkungsgrad betrieben wird und dennoch die Funktionsweise bei einfachem Aufbau möglichst wenig beeinflusst wird.

In einem ersten Aspekt wird die obige Aufgabe durch ein Verfahren zur Frequenzregelung eines piezoelektrischen Transformators nach Anspruch 1 gelöst.

Das Verfahren umfasst unter anderem die Schritte:
- Anregen eines piezoelektrischen Transformators an einer Eingangsseite mit einer Wechselspannung vorbestimmter Frequenz als Eingangsspannung,
- Erfassen einer Phaseninformation der Eingangsimpedanz des piezoelektrischen Transformators in einem Rückführpfad,
- Auswerten der erfassten Phaseninformation hinsichtlich eines vorbestimmten Phasenkriteriums,
- Regeln der Frequenz der Wechselspannung in Abhängigkeit von der ausgewerteten Phaseninformation.

Gemäß einem derartigen Verfahren erfolgt eine Detektion einer Phaseninformation, also einer Information über den Phasenwinkel zwischen sinusförmiger Eingangsspannung und sinusförmigem Eingangsstrom, der dem Phasenwinkel der Eingangsimpedanz entspricht. Schließlich kann die Frequenz der Wechselspannung in Abhängigkeit von der ausgewerteten Phaseninformation geregelt werden.

Der Vorteil eines solchen Verfahrens besteht darin, dass für eine Frequenzregelung lediglich eine an der Eingangsseite des piezoelektrischen Transformators erfasste Information als Kriterium für die Frequenzregelung verwendet wird. Auf diese Weise wird das Betriebsverhalten des piezoelektrischen Transformators praktisch kaum oder nur unwesentlich beeinflusst. Insbesondere entfällt das Abgreifen von Signalinformationen an der Ausgangsseite des piezoelektrischen Transformators. Dennoch kann der piezoelektrische Transformator allein aufgrund der eingangsseitig erfassten Information stets bei optimalen Bedingungen betrieben werden. Ein entscheidender Vorteil gegenüber herkömmlichen Konzepten ist der hohe Wirkungsgrad, der dabei erzielt werden kann.

Ein wesentliches Prinzip des Verfahrens besteht darin, dass es alleine aufgrund der Phase beziehungsweise des Phasenwinkels der Eingangsimpedanz des piezoelektrischen Transformators möglich ist, den Transformator bei beliebigen äußeren Bedingungen jeweils bei maximalem Wirkungsgrad zu betreiben. Das bedeutet, dass allein aufgrund einer Auswertung der erfassten Phaseninformation hinsichtlich eines vorbestimmten Phasenkriteriums algorithmisch auf eine bestimmte Betriebsfrequenz geschlossen werden kann, bei der das vorbestimmte Phasenkriterium erfüllt ist und ein maximaler Wirkungsgrad gegeben ist. Somit kann der piezoelektrische Transformator auf eine Betriebsfrequenz der Wechselspannung geregelt werden, so dass der Transformator mit dieser Frequenz bei einem maximalen Wirkungsgrad arbeitet.

Bei dem Verfahren der erläuterten Art wird das vorbestimmte Phasenkriterium vorteilhaft als eine oder mehrere Nullstellen oder eine lokale Extremstelle des Phasenwinkels der Eingangsimpedanz als Funktion der Frequenz der Wechselspannung gewählt. Zum Beispiel kann die lokale Extremstelle ein lokales Minimum des Phasenwinkels der Eingangsimpedanz sein. Das Auswerten der erfassten Phaseninformation umfasst vorteilhaft eine Bewertung des hinreichenden Erfüllens des vorbestimmten Phasenkriteriums. Der Verlauf des Phasenwinkels der Eingangsimpedanz als Funktion der Frequenz der Wechselspannung lässt somit Rückschlüsse auf bestimmte Betriebsfrequenzen zu, an denen ein Wirkungsgrad des piezoelektrischen Transformators bei bestimmten Betriebsbedingungen optimal ist.

Durch mathematisches Formulieren eines oder mehrerer dieser Phasenkriterien und eine entsprechende Implementierung einer Regelung kann eine kontinuierliche Regelung der Frequenz derart erfolgen, dass stets die erfasste Phaseninformation dahingehend ausgewertet wird, ob das oder die Phasenkriterien hinreichend erfüllt sind. Somit kann auf eine mit einem entsprechenden Phasenkriterium einhergehende Betriebsfrequenz als optimale Betriebsfrequenz des piezoelektrischen Transformators mit maximalem Wirkungsgrad geregelt werden. Auf diese Weise ist es möglich, allein durch Auswerten des Phasenwinkels über der Frequenz eine optimale Betriebsfrequenz des piezoelektrischen Transformators zu ermitteln.

Im Rückführpfad wird vermittels eines Phasendetektors ein Signal der Eingangsspannung mit einem Signal proportional zum Eingangsstrom an der Eingangsseite des piezoelektrischen Transformators verglichen und daraus ein Ausgangssignal des Phasendetektors ermittelt. Dieses Ausgangssignal des Phasendetektors ist proportional zum Betrag des Phasenwinkels zwischen der Eingangsspannung und dem Eingangsstrom und dient als Phaseninformation der Eingangsimpedanz des piezoelektrischen Transformators. Derartige Maßnahmen erlauben, mit einfachen Mitteln anhand eines Vergleichs von Eingangsspannung und Eingangsstrom auf den Phasenversatz dieser beiden elektrischen Größen zu schließen.

In einer anderen, nicht beanspruchten Konstellation wird im Rückführpfad vermittels eines Impedanz-Analysators ein Signal proportional zum Eingangsstrom an der Eingangsseite des piezoelektrischen Transformators abgetastet. Aus den Abtastwerten wird vermittels einer Fourier-Transformation der Phasenwinkel des Signals berechnet, der schließlich als Phaseninformation der Eingangsimpedanz des piezoelektrischen Transformators dient. Auch auf solche Art und Weise kann der Phasenwinkel zur Regelung der optimalen Betriebsfrequenz ermittelt werden.

Vorteilhaft wird bei dem Verfahren der erläuterten Art der piezoelektrische Transformator als Plasmagenerator derart betrieben, dass eine Eingangsspannung mit einer verfahrensgemäß geregelten Frequenz an der Eingangsseite in eine Ausgangsspannung gewandelt wird, wodurch an der Ausgangsseite aufgrund von Ionisation eines den Plasmagenerator umströmenden Arbeitsgases ein Plasma erzeugt wird. Das Arbeitsgas kann beispielsweise Luft oder aber auch ein Edelgas (z.B. Argon) sein.

Insbesondere bei einem entsprechenden Betrieb des piezoelektrischen Transformators als Plasmagenerator hängt eine Frequenz, bei der der Plasmagenerator einen maximalen Wirkungsgrad hat, von zahlreichen Parametern, unter anderem auch von der verwendeten Arbeitsumgebung (Arbeitsgas, Temperatur, etc.) ab. Vermittels des erläuterten Verfahrens zur Frequenzregelung kann der Betrieb des Plasmagenerators, insbesondere seine Betriebsfrequenz, an unterschiedliche Arbeitsumgebungen und Betriebsbedingungen angepasst werden. Aufgrund der rein eingangsseitigen Erfassung der erforderlichen Information für die Frequenzregelung wird das Betriebsverhalten des Plasmagenerators an seiner Ausgangsseite und damit die Plasmaerzeugung, nicht negativ beeinflusst. Dennoch kann der Plasmagenerator bei stets optimalen Bedingungen betrieben werden. Dadurch wird auch eine Erwärmung des piezoelektrischen Elementes bzw. Bauteils auf ein Minimum reduziert. Des Weiteren kann der Plasmagenerator auch bei höheren Plasmaleistungen betrieben werden.

Ein weiterer Vorteil der Anwendung des erläuterten Verfahrens zur Frequenzregelung bei Betrieb eines piezoelektrischen Plasmagenerators besteht darin, dass auf eine Fehlbedienung (z.B. Zünden gegen leitfähige Gegenstände, Berührung, etc.) reagiert werden kann. Denn derartige Situationen führen dazu, dass die Phase bzw. der Phasenwinkel der Eingangsimpedanz stark verändert wird, was durch das erläuterte Verfahren erkannt werden kann. Dadurch kann eine Ansteuerung beispielsweise die Eingangsleistung reduzieren.

In einem weiteren Aspekt wird die oben genannte Aufgabe durch eine Schaltungsanordnung nach Anspruch 4 gelöst. Die Schaltungsanordnung umfasst unter anderem :
- einen piezoelektrischen Transformator mit einer Eingangsseite und einer Ausgangsseite,
- eine Wechselspannungsquelle zur Erzeugung einer Eingangsspannung vorbestimmter Frequenz an der Eingangsseite des piezoelektrischen Transformators,
- eine Detektionsvorrichtung, die in einem Rückführpfad zwischen der Eingangsseite des piezoelektrischen Transformators und der Wechselspannungsquelle eingerichtet ist zum Erfassen einer Phaseninformation der Eingangsimpedanz des piezoelektrischen Transformators, sowie
- eine Regelungsvorrichtung, die eingerichtet ist, die erfasste Phaseninformation hinsichtlich eines vorbestimmten Phasenkriteriums auszuwerten und der Wechselspannungsquelle in Abhängigkeit von der ausgewerteten Phaseninformation eine Frequenz zur Erzeugung der Eingangsspannung vorzugeben.

Eine derartige Schaltungsanordnung hat gegenüber herkömmlichen Regelungsanordnungen zur Frequenzregelung eines piezoelektrischen Transformators den Vorteil, dass eine Frequenzregelung des piezoelektrischen Transformators allein durch eine an der Eingangsseite des Transformators erfasste Information durchführbar ist. Wie bereits im Zusammenhang mit dem obigen Verfahren erläutert, erfolgt die Frequenzregelung auf Basis einer erfassten Phaseninformation der Eingangsimpedanz des piezoelektrischen Transformators. Dies erlaubt einen einfachen Aufbau der Schaltungsanordnung und dennoch eine optimale Regelung des Transformators hinsichtlich einer Betriebsfrequenz mit maximalem Wirkungsgrad. Ferner beeinflusst die Schaltungsanordnung den Betrieb des Transformators nicht negativ, weil die zur Regelung notwendige Information lediglich an der Eingangsseite des piezoelektrischen Transformators abgegriffen wird.

Die Detektionsvorrichtung umfasst einen Phasendetektor, der derart verschaltet ist, dass an einem ersten Eingang des Phasendetektors das Signal der Eingangsspannung anliegt und an einem zweiten Eingang des Phasendetektors ein Signal proportional zum Eingangsstrom an der Eingangsseite des piezoelektrischen Transformators anliegt. Dabei ist der Phasendetektor eingerichtet, an einem Ausgang ein Ausgangssignal auszugeben, das die Phaseninformation der Eingangsimpedanz umfasst. Durch einen derartigen Phasendetektor kann auf einfache Weise die Phaseninformation der Eingangsimpedanz erfasst werden.

Gemäß einer alternativen, nicht beanspruchten Ausführung umfasst die Detektionsvorrichtung einen Impedanz-Analysator, der derart verschaltet ist, dass an seinem Eingang ein Signal proportional zum Eingangsstrom an der Eingangsseite des piezoelektrischen Transformators anliegt. Der Impedanz-Analysator ist eingerichtet, das Signal abzutasten und die Abtastwerte einer Fourier-Transformation zuzuführen zur Berechnung des Phasenwinkels des Signals. Dieser Phasenwinkel entspricht dem Phasenwinkel der Eingangsimpedanz des piezoelektrischen Transformators.

Vorteilhaft ist in der Schaltungsanordnung der erläuterten Art der piezoelektrische Transformator ein piezoelektrischer Plasmagenerator, der eingerichtet ist, aus der Eingangsspannung an der Eingangsseite eine Ausgangshochspannung an der Ausgangsseite zu erzeugen, so dass an der Ausgangsseite aufgrund von Ionisation eines den Plasmagenerator umströmenden Arbeitsgases ein Plasma erzeugt wird.

Weitere vorteilhafte Ausführungen sind in den Unteransprüchen sowie in der nachfolgenden Figurenbeschreibung offenbart.

Die Erfindung wird im Folgenden anhand von Ausführungsbeispielen unter Zuhilfenahme mehrerer Figuren näher erläutert.

Es zeigen:
- Figur 1: unterschiedliche Verläufe des Betrags sowie des Phasenwinkels der Eingangsimpedanz eines piezoelektrischen Plasmagenerators über der Frequenz,
- Figur 2: unterschiedliche Verläufe des Wirkungsgrades des piezoelektrischen Plasmagenerators in Zusammenhang mit Figur 1 über der Frequenz,
- Figur 3A: eine Schaltungsanordnung zur Frequenzregelung eines piezoelektrischen Plasmagenerators gemäß einer Ausführungsform,
- Figur 3B: den Aufbau einer Detektionsvorrichtung in einer Schaltungsanordnung gemäß Figur 3A, sowie
- Figur 4: eine Schaltungsanordnung zur Frequenzregelung eines piezoelektrischen Plasmagenerators gemäß einer weiteren Ausführungsform.

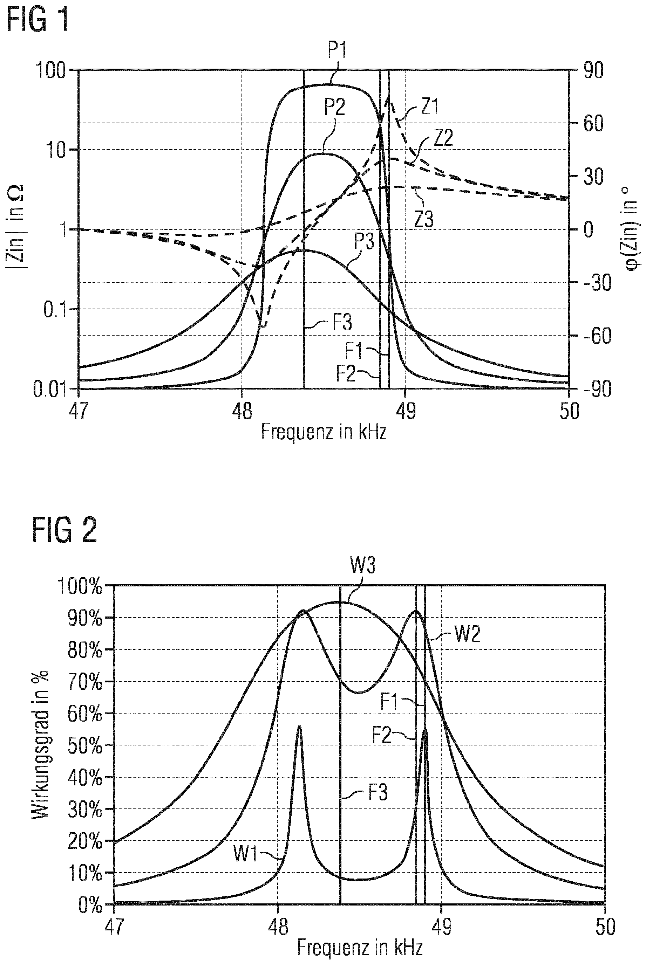

Figur 1 zeigt unterschiedliche Verläufe Z1, Z2, Z3 des Betrages der Eingangsimpedanz ("|Zin|") in Ohm (Ω) eines piezoelektrischen Plasmagenerators sowie unterschiedliche Verläufe P1, P2, P3 des entsprechenden Phasenwinkels phi der Eingangsimpedanz ("ϕ(Zin)") in Grad (°) über der Frequenz in kHz. Die folgenden Erläuterungen betreffen dabei eine Ansteuerung des piezoelektrischen Plasmagenerators bei Antiresonanz. Das zugrunde liegende Prinzip ist aber auch für Plasmageneratoren gültig, welche für den Betrieb in Resonanz ausgelegt werden.

Figur 1 zeigt unterschiedliches Betriebsverhalten eines entsprechend betriebenen Plasmagenerators. Die Verläufe Z1 und P1 repräsentieren ein erstes Betriebsverhalten. Hierbei wird der Plasmagenerator mit einer kleinen Eingangsspannung angeregt, so dass die Ausgangsspannung nicht hoch genug ist, um ein Plasma zu generieren. In diesem Fall kann der Plasmagenerator wie ein piezoelektrischer Transformator im Leerlauf beschrieben werden. Dabei ist der Wirkungsgrad am höchsten bei 0° Phasenwinkel und gleichzeitig bei einem Maximum der Impedanz. Dies ist in Figur 1 dadurch verdeutlicht, dass die Kennlinie P1 einen Nulldurchgang bei der Frequenz F1 (siehe senkrechte Markierung) umfasst, an der ein Maximum des Betrages der Impedanz Z1 vorliegt. Figur 2 zeigt an der entsprechenden Frequenz (siehe senkrechte Markierung F1) im Verlauf des Wirkungsgrades W1 ein lokales Maximum.

Erhöht man die Eingangsspannung, so beginnt der Plasmagenerator Plasma zu generieren. Dieses Verhalten lässt sich näherungsweise als spannungsabhängiger Lastwiderstand am Ausgang des piezoelektrischen Plasmagenerators beschreiben. Dieses Betriebsverhalten ist in Figur 1 durch die Kennlinien P2 beziehungsweise Z2 repräsentiert. Im Unterschied zum Verhalten der Kennlinien P1 und Z1 ist der Wirkungsgrad in diesem Betriebsverhalten nicht mehr am höchsten bei einem Maximum der Impedanz (vgl. lokales Maximum der Kennlinie Z2 in Figur 1), sondern nurmehr bei 0° Phasenwinkel (vgl. Nullstelle der Kennlinie P2 bei einer entsprechend niedrigeren Frequenz F2). Figur 2 zeigt dieses Verhalten, bei dem der Verlauf des Wirkungsgrades W2 bei F2 ein lokales Maximum aufweist.

Wird die Spannung am Eingang des Plasmagenerators weiter erhöht, so gibt es einen Punkt, an dem das induktive Verhalten des Bauteils zur Gänze verschwindet und der Phasenwinkel stets kleiner als 0° ist. Siehe Verlauf der Kennlinien P3 und Z3 in Figur 1. Hier befindet sich der maximale Wirkungsgrad bei einem Maximum des Phasenwinkels P3 bei der Frequenz F3. Vergleiche hierzu auch das lokale Maximum des Wirkungsgradverlaufs W3 in Figur 2 bei der Frequenz F3.

Aus den oben erläuterten Untersuchungen, wie sie die Figuren 1 und 2 belegen, folgt, dass es alleine aufgrund des frequenzabhängigen Verlaufs des Phasenwinkels möglich ist, den Plasmagenerator bei beliebigen äußeren Bedingungen jeweils bei maximalem Wirkungsgrad zu betreiben.

Diese Erkenntnis kann für eine Frequenzregelung des Plasmagenerators nutzbar gemacht werden.

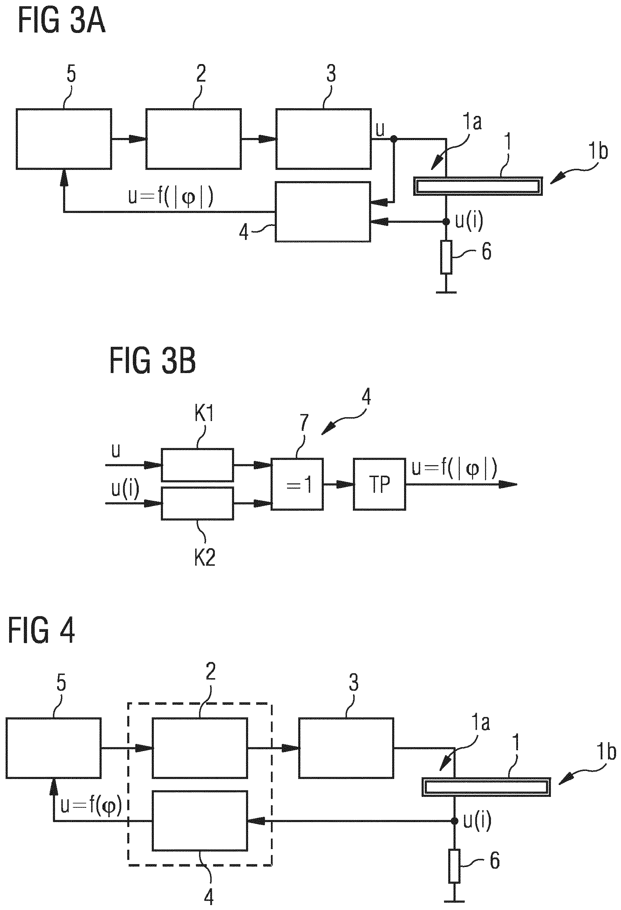

Figur 3A zeigt eine Ausführungsform einer Schaltungsanordnung zur Frequenzregelung eines entsprechenden Plasmagenerators.

Insbesondere umfasst die Schaltungsanordnung einen piezoelektrischen Transformator 1, der als piezoelektrischer Plasmagenerator arbeitet. Der piezoelektrische Transformator 1 umfasst eine Eingangsseite 1a und eine Ausgangsseite 1b. Eingangsseitig ist eine Wechselspannungsquelle 2 geschaltet, die eine sinusförmige Wechselspannung zur Anregung des piezoelektrischen Transformators 1 an dessen Eingangsseite 1a erzeugt. Die Wechselspannungsquelle 2 kann beispielsweise ein DDS-Sinus-Generator sein (DDS = Direkte digitale Synthese). Es ist jedoch auch möglich, die Wechselspannungsquelle 2 als analogen spannungsgeregelten Oszillator ""Voltage Controlled Oscillator", VCO) auszuführen.

Die so erzeugte Wechselspannung wird über einen Leistungsverstärker 3 vorverstärkt, so dass an der Eingangsseite 1a des piezoelektrischen Transformators 1 ein Eingangsspannungssignal u anliegt. Über diese Eingangsspannung u kann der piezoelektrische Transformator 1 zur mechanischen Schwingung angeregt werden, so dass an dessen Ausgangsseite 1b eine Ausgangshochspannung zur Plasmaerzeugung eines den piezoelektrischen Transformator 1 umströmenden Arbeitsgases, z. B. Luft, erzeugt wird.

Ferner ist in einem Rückführpfad der Schaltungsanordnung gemäß Figur 3A eine Detektionsvorrichtung 4 eingerichtet, der sowohl das Eingangsspannungssignal u als auch ein Signal u(i) zugeführt wird. Letzteres ist ein Spannungssignal proportional zum Eingangsstrom i an der Eingangsseite 1a des Transformators 1. Das Signal u(i) wird über einen Stromshunt 6 gewonnen. Die beiden Signale u und u(i) werden in der Detektionsvorrichtung 4 zu einem Ausgangssignal u=f(|ϕ|) verarbeitet (Spannungssignal als Funktion des Betrages des Phasenwinkels der Eingangsimpedanz des Transformators 1). In dieser Ausführungsform ist das Ausgangssignal proportional zum Betrag des Phasenwinkels. Mit anderen Worten repräsentiert das Ausgangssignal der Detektionsvorrichtung 4 eine Phaseninformation, konkret den Phasenversatz (Phasenwinkel) zwischen der zeitabhängigen Eingangsspannung u und dem zeitabhängigen Eingangsstrom (repräsentiert durch das Signal u(i)) an der Eingangsseite 1a des Transformators 1.

Das Ausgangssignal der Detektionsvorrichtung 4 wird weiterhin einer Regelungsvorrichtung 5 zugeführt, die das Ausgangssignal auswertet. In Abhängigkeit von dieser Auswertung wird gegebenenfalls eine neue (bzw. um einen bestimmten Betrag geänderte) Frequenz berechnet, die der Wechselspannungsquelle 2 als Stellsignal zugeführt wird. Die Regelungsvorrichtung 5 kann beispielsweise als Microcontroller eingerichtet sein. Insbesondere wertet die Regelungsvorrichtung 5 die über die Detektionsvorrichtung 4 erfasste und als Ausgangssignal ausgegebene Phaseninformation dahingehend aus, ob der erfasste Phasenwinkel der Eingangsimpedanz des Transformators 1 einem vorbestimmten Phasenkriterium genügt oder nicht. Hierbei wertet die Regelungsvorrichtung 5 vorteilhaft das hinreichende Erfüllen bzw. Erreichen eines Null-Durchgang (Nullstelle) beziehungsweise einer lokalen Extremstelle des Phasenwinkels aus. Wie zu Figur 1 und Figur 2 erläutert, befinden sich nämlich an diesen Stellen der Verläufe des entsprechenden Phasenwinkels über der Frequenz in den jeweiligen Betriebssituationen die maximal zu erzielenden Wirkungsgrade des Transformators 1.

Es ist denkbar, ausgehend von einer bestimmten Frequenz eine Regelung derart durchzuführen, dass die Frequenz kontinuierlich geändert wird und der erfasste Phasenwinkel der Eingangsimpedanz des Transformators gemäß den erläuterten Maßnahmen hinsichtlich des Annäherns und schließlich hinreichenden Erfüllens des vorbestimmten Phasenkriteriums ausgewertet wird. Diese Regelung kann während eines kontinuierlichen Betriebs des piezoelektrischen Transformators 1 erfolgen. Alternativ ist auch denkbar, für eine spezifische Betriebssituation initial ein vorbestimmtes Frequenzband zu durchlaufen (z.B. vermittels eines Sweep- oder Chirp-Signals), den Phasenwinkel hinsichtlich des angestrebten Phasenkriteriums auszuwerten und anschließend auf die geeignete Frequenz zu regeln, bei der das Phasenkriterium hinreichend erfüllt wird. Danach kann der piezoelektrische Transformator 1 mit dieser Frequenz optimal betrieben werden. Hier kann ergänzend auch eine weitere Nachregelung während des Betriebes erfolgen, z.B. wenn sich bestimmte Betriebsparameter wie Arbeitsgasmenge, Temperatur, usw. ändern.

Erfüllt eine erfasste Phaseninformation ein erläutertes Phasenkriterium hinreichend (z.B. in einem vorbestimmten kleinen Bereich um das definierte Phasenkriterium herum), so kann der Transformator 1 gemäß Figur 3A an der korrespondierenden Frequenz in einem optimalen Wirkungsgrad betrieben werden. Die Schaltungsanordnung gemäß Figur 3A hat somit den Vorteil, dass anhand einer erfassten Phaseninformation der Eingangsimpedanz des Transformators 1 auf eine optimale Betriebsfrequenz geregelt werden kann, bei der ein vorbestimmtes Phasenkriterium (vgl. Figuren 1 und 2) erfüllt ist.

Figur 3B zeigt die Detektionsvorrichtung 4 gemäß Figur 3A in einer Detailansicht. Die Detektionsvorrichtung 4 ist hierbei als Phasendetektor ausgeführt. Zunächst wird das Eingangsspannungssignal u sowie das Signal u(i), welches proportional zum Eingangsstrom ist, jeweils einem Komparator K1 und K2 zugeführt zur Bestimmung des Null-Durchgangs der jeweiligen Signale. Anschließend werden die so verarbeiteten Signale an die Eingänge eines XOR-Gatters 7 (XOR = Exklusiv ODER) angelegt. das XOR-Gatter 7 gibt an seinem Ausgang einen High-Pegel aus, so lange die Signale u und u(i) umgekehrte Vorzeichen haben. Umgekehrt gibt das XOR-Gatter 7 einen Low-Pegel aus, so lange die Signale u und u(i) gleiches Vorzeichen haben. Das Ausgangssignal des XOR-Gatters 7 wird ferner an einen Tiefpass TP weitergeleitet, welcher das Signal des XOR-Gatters 7 mittelt. Das so gewonnene Ausgangssignal u=f(|ϕ|) (Spannungssignal als Funktion des Betrages des Phasenwinkels der Eingangsimpedanz des Transformators 1) beträgt Null, wenn die Signale u und u(i) in Phase sind. Sind die Signale um +180 Grad beziehungsweise -180 Grad phasenverschoben, so ist das Ausgangssignal maximal.

Auf diese Weise kann der so ausgeführte Phasendetektor 4 zwar nicht zwischen positiver und negativer Phase unterscheiden, man erhält jedoch ein Signal (Phasensignal), welches proportional zum Betrag des Phasenwinkels ist. Dieses Signal kann an die Regelungsvorrichtung 5 (vgl. Figur 3A) übergeben werden, in der über einen entsprechenden Algorithmus durch iteratives Ändern der Frequenz und Auswerten des Phasensignals das Annähern bzw. Erreichen des gewünschten Phasenkriteriums ermittelt wird, welches schließlich zur optimalen Betriebsfrequenz führt. Ein entsprechender Algorithmus kann beispielsweise ein Null-Stellen-Verfahren und/oder einen Extremwert-Suchalgorithmus umfassen. Es ist beispielsweise auch denkbar, LQ-Regelungsverfahren zum optimierten Auffinden eines optimalen Phasenkriteriums (als Gütefunktional) zur Bestimmung der entsprechenden Betriebsfrequenz einzusetzen. Hier sind vielerlei Regelungsalgorithmen oder auch Kombinationen entsprechender Verfahren denkbar.

Figur 4 zeigt eine alternative, nicht erfindungsgemäße, Ausführungsform einer Schaltungsanordnung zur Frequenzregelung eines piezoelektrischen Transformators 1. Die Schaltungsanordnung entspricht in einigen wesentlichen Komponenten der Schaltungsanordnung gemäß Figur 3A. Einziger Unterschied der Schaltungsanordnung gemäß Figur 4 besteht darin, dass die Detektionsvorrichtung 4 und die Wechselspannungsquelle 2 konstruktiv in einem Modul vereint sind und die Detektionsvorrichtung 4 als Impedanz-Analysator eingerichtet ist. Somit wird der Detektionsvorrichtung 4 im Rückführzweig der Schaltungsanordnung lediglich ein Spannungssignal u(i) übergeben, welches analog zur Figur 3A über einen Stromshunt 6 gebildet wird und proportional zum Eingangsstrom auf der Eingangsseite 1a des piezoelektrischen Transformators 1 ist. Das Signal u(i) wird im Impedanz-Analysator 4 überabgetastet und aus den Abtastwerten der entsprechende Phasenwinkel des Signals per Fourier-Transformation bestimmt. Hier kann beispielsweise ein algorithmisches Verfahren einer Fast-Fourier-Transformation (FFT) angewandt werden. Ein entsprechendes Ausgangssignal u=f(ϕ) kann dann an die Regelungsvorrichtung 5 übergeben und darin komfortabel ausgewertet werden. Die Regelungsvorrichtung 5 kann beispielsweise per Software die Frequenz als Stellgröße für die Wechselspannungsquelle 2 nachregeln. Eine Auswertung des Phasenwinkels über einen Impedanz-Analysator 4 gemäß Figur 4 hat den Vorteil, dass auch das Vorzeichen des Phasenwinkels berücksichtigt und in eine Auswertung einbezogen werden kann.

Die dargestellten Ausführungsformen sind lediglich beispielhaft gewählt. Das hier erläuterte Regelungsverfahren beziehungsweise die erläuterte Schaltungsanordnung erlauben eine Frequenzregelung eines piezoelektrischen Transformators, insbesondere eines piezoelektrischen Plasmagenerators, zum Einstellen einer optimalen Betriebsfrequenz in jeweiligen Betriebssituationen derart, dass der piezoelektrische Transformator mit einem optimalen Wirkungsgrad betrieben werden kann. Der Vorteil des Verfahrens beziehungsweise der Schaltungsanordnung liegt darin, dass eine entsprechende Regelungsinformation lediglich aus Signalen gewonnen wird, die an einer Eingangsseite des Transformators abgegriffen werden können. Auf diese Weise entfallen ein Abgreifen und Rückführen von Signalen an einer Ausgangsseite des Transformators, wodurch der Betrieb des Transformators negativ beeinflusst würde. Ferner erlaubt eine entsprechende Schaltungsanordnung einen einfachen Aufbau.

### Bezugszeichenliste

- 1: piezoelektrischer Transformator
- 1a: Eingangsseite
- 1b: Ausgangsseite
- 2: Wechselspannungsquelle
- 3: Leistungsverstärker
- 4: Detektionsvorrichtung
- 5: Regelungsvorrichtung
- 6: Stromshunt
- 7: XOR-Gatter
- F1, F2, F3: Frequenzlinien
- K1: Komparator
- K2: Komparator
- P1, P2, P3: Phasenwinkel
- TP: Tiefpass
- Z1, Z2, Z3: Impedanzbetrag

## Patentansprüche

1. Verfahren zur Frequenzregelung eines piezoelektrischen Transformators (1), umfassend die Schritte:
- Anregen eines piezoelektrischen Transformators (1) an einer Eingangsseite (1a) mit einer Wechselspannung vorbestimmter Frequenz als Eingangsspannung,
- Erfassen einer Phaseninformation der Eingangsimpedanz des piezoelektrischen Transformators (1) in einem Rückführpfad,
- Auswerten der erfassten Phaseninformation hinsichtlich eines vorbestimmten Phasenkriteriums,
- Regeln der Frequenz der Wechselspannung in Abhängigkeit von der ausgewerteten Phaseninformation,
wobei im Rückführpfad vermittels eines Phasendetektors, umfassend ein XOR-Gatter (7) und einen Tiefpass (TP), welche in Reihe geschaltet sind, ein Signal der Eingangsspannung mit einem Signal proportional zum Eingangsstrom an der Eingangsseite des piezoelektrischen Transformators (1) verglichen wird, wobei an einem ersten Eingang des XOR-Gatters (7) ein Vorzeichensignal der Eingangsspannung angelegt wird und an einem zweiten Eingang des XOR-Gatters (7) ein Vorzeichensignal proportional zum Eingangsstrom an der Eingangsseite (1a) des piezoelektrischen Transformators (1) angelegt wird derart, dass am Ausgang des XOR-Gatters (7) ein Ausgangssignal als Vergleichssignal erzeugt wird, das vermittels des Tiefpasses (TP) zu einem Signal gemittelt wird, das proportional zum Betrag des Phasenwinkels der Eingangsimpedanz des piezoelektrischen Transformators (1) ist und als Phaseninformation der Eingangsimpedanz des piezoelektrischen Transformators (1) dient.

2. Verfahren nach Anspruch 1, wobei das vorbestimmte Phasenkriterium als eine Nullstelle oder eine lokale Extremstelle des Phasenwinkels der Eingangsimpedanz als Funktion der Frequenz der Wechselspannung gewählt wird und das Auswerten der erfassten Phaseninformation eine Bewertung des hinreichenden Erfüllens des vorbestimmten Phasenkriteriums umfasst.

3. Verfahren nach einem der Ansprüche 1 oder 2, wobei der piezoelektrische Transformator (1) als Plasmagenerator derart betrieben wird, dass eine Eingangsspannung mit einer verfahrensgemäß geregelten Frequenz an der Eingangsseite (1a) in eine Ausgangshochspannung gewandelt wird, wobei an der Ausgangsseite (1b) aufgrund von Ionisation eines den Plasmagenerator umströmenden Arbeitsgases ein Plasma erzeugt wird.

4. Schaltungsanordnung umfassend:
- einen piezoelektrischen Transformator (1) mit einer Eingangsseite (1a) und einer Ausgangsseite (1b),
- eine Wechselspannungsquelle (2) zur Erzeugung einer Eingangsspannung vorbestimmter Frequenz an der Eingangsseite (1a) des piezoelektrischen Transformators (1),
- eine Detektionsvorrichtung (4), die in einem Rückführpfad zwischen der Eingangsseite (1a) des piezoelektrischen Transformators (1) und der Wechselspannungsquelle (2) eingerichtet ist zum Erfassen einer Phaseninformation der Eingangsimpedanz des piezoelektrischen Transformators (1), sowie
- eine Regelungsvorrichtung (5), die eingerichtet ist, die erfasste Phaseninformation hinsichtlich eines vorbestimmten Phasenkriteriums auszuwerten und der Wechselspannungsquelle (2) in Abhängigkeit von der ausgewerteten Phaseninformation eine Frequenz zur Erzeugung der Eingangsspannung vorzugeben, wobei
- die Detektionsvorrichtung (4) einen Phasendetektor umfasst,
- der Phasendetektor ein XOR-Gatter (7) und einen Tiefpass (TP) umfasst, welche in Reihe geschaltet sind, und
- an einem ersten Eingang des XOR-Gatters (7) ein Vorzeichensignal der Eingangsspannung anliegt und an einem zweiten Eingang des XOR-Gatters (7) ein Vorzeichensignal proportional zum Eingangsstrom an der Eingangsseite (1a) des piezoelektrischen Transformators (1) anliegt derart, dass am Ausgang des XOR-Gatters (7) ein Ausgangssignal umfassend die Phaseninformation der Eingangsimpedanz als Vergleichssignal erzeugbar ist, das vermittels des Tiefpasses (TP) zu einem Signal mittelbar ist, das proportional zum Betrag des Phasenwinkels der Eingangsimpedanz des piezoelektrischen Transformators (1) ist.

5. Schaltungsanordnung nach Anspruch 4, wobei der piezoelektrische Transformator (1) ein piezoelektrischer Plasmagenerator ist, der eingerichtet ist, aus der Eingangsspannung an der Eingangsseite (1a) eine Ausgangshochspannung an der Ausgangsseite (1b) zu erzeugen, so dass an der Ausgangsseite (1b) aufgrund von Ionisation eines den Plasmagenerator umströmenden Arbeitsgases ein Plasma erzeugt wird.

## Claims

1. Method for frequency regulation for a piezoelectric transformer (1), comprising the steps of:
- exciting a piezoelectric transformer (1) on an input side (1a) with an AC voltage of predetermined frequency as input voltage,
- capturing a piece of phase information for the input impedance of the piezoelectric transformer (1) in a feedback path,
- evaluating the captured phase information in respect of a predetermined phase criterion,
- regulating the frequency of the AC voltage on the basis of the evaluated phase information,
wherein a phase detector comprising an XOR gate (7) and a low-pass filter (TP), which are connected in series, is used in the feedback path to compare a signal for the input voltage with a signal proportional to the input current on the input side of the piezoelectric transformer (1), wherein an arithmetic sign signal for the input voltage is applied to a first input of the XOR gate (7) and an arithmetic sign signal proportional to the input current on the input side (1a) of the piezoelectric transformer (1) is applied to a second input of the XOR gate (7) such that an output signal is produced at the output of the XOR gate (7) as a comparison signal that is averaged by means of the low-pass filter (TP) to produce a signal that is proportional to the absolute value of the phase angle of the input impedance of the piezoelectric transformer (1) and serves as phase information for the input impedance of the piezoelectric transformer (1).

2. Method according to Claim 1, wherein the predetermined phase criterion is chosen as a zero or a local extreme of the phase angle of the input impedance as a function of the frequency of the AC voltage, and the evaluating of the captured phase information comprises a rating of the adequate satisfaction of the predetermined phase criterion.

3. Method according to either of Claims 1 and 2, wherein the piezoelectric transformer (1) is operated as a plasma generator such that an input voltage at a frequency regulated in accordance with the method, on the input side (1a), is converted into an output high voltage, a plasma being produced on the output side (1b) on account of ionization of an operating gas flowing around the plasma generator.

4. Circuit arrangement comprising:
- a piezoelectric transformer (1) having an input side (1a) and an output side (1b),
- an AC voltage source (2) for producing an input voltage of predetermined frequency on the input side (1a) of the piezoelectric transformer (1),
- a detection apparatus (4) that is set up in a feedback path between the input side (1a) of the piezoelectric transformer (1) and the AC voltage source (2) to capture a piece of phase information for the input impedance of the piezoelectric transformer (1), and
- a regulating apparatus (5) that is set up to evaluate the captured phase information in respect of a predetermined phase criterion and to prescribe a frequency for producing the input voltage to the AC voltage source (2) on the basis of the evaluated phase information, wherein
- the detection apparatus (4) comprises a phase detector,
- the phase detector comprises an XOR gate (7) and a low-pass filter (TP), which are connected in series, and
- an arithmetic sign signal for the input voltage is applied to a first input of the XOR gate (7) and an arithmetic sign signal proportional to the input current on the input side (1a) of the piezoelectric transformer (1) is applied to a second input of the XOR gate (7) such that an output signal comprising the phase information of the input impedance is able to be produced at the output of the XOR gate (7) as a comparison signal that is able to be averaged by means of the low-pass filter (TP) to produce a signal that is proportional to the absolute value of the phase angle of the input impedance of the piezoelectric transformer (1).

5. Circuit arrangement according to Claim 4, wherein the piezoelectric transformer (1) is a piezoelectric plasma generator that is set up to produce an output high voltage on the output side (1b) from the input voltage on the input side (1a), so that a plasma is produced on the output side (1b) on account of ionization of an operating gas flowing around the plasma generator.

## Revendications

1. Procédé de régulation en fréquence d'un transformateur piézoélectrique (1), le procédé comprenant les étapes suivantes :
- exciter un transformateur piézoélectrique (1) sur un côté entrée (1a) avec une tension alternative de fréquence prédéterminée comme tension d'entrée,
- acquérir une information de phase de l'impédance d'entrée du transformateur piézoélectrique (1) dans un chemin de rétroaction,
- évaluer l'information de phase acquise quant à un critère de phase prédéterminé,
- réguler la fréquence de la tension alternative en fonction de l'information de phase évaluée,
un signal de la tension d'entrée étant comparé à un signal proportionnel au courant d'entrée, du côté entrée du transformateur piézoélectrique (1), dans le chemin de rétroaction au moyen d'un détecteur de phase comprenant une porte XOR (7) et un filtre passe-bas (TP), qui sont montés en série, un signal de signe de la tension d'entrée étant appliqué à une première entrée de la porte XOR (7) et un signal de signe proportionnel au courant d'entrée du côté d'entrée (1a) du transformateur piézoélectrique (1) étant appliqué à une deuxième entrée de la porte XOR (7) de sorte qu'un signal de sortie est généré en tant que signal de comparaison à la sortie de la porte XOR (7) et est moyenné au moyen du filtre passe-bas (TP) pour former un signal qui est proportionnel à la valeur de l'angle de phase de l'impédance d'entrée du transformateur piézoélectrique (1) et qui est utilisé comme information de phase de l'impédance d'entrée du transformateur piézoélectrique (1).

2. Procédé selon la revendication 1, le critère de phase prédéterminé étant choisi comme zéro ou comme extrême local de l'angle de phase de l'impédance d'entrée en fonction de la fréquence de la tension alternative, et l'évaluation de l'information de phase acquise comprenant une évaluation du critère de phase prédéterminé comme étant suffisamment rempli ou non.

3. Procédé selon l'une des revendications 1 et 2, le transformateur piézoélectrique (1) fonctionnant en tant que générateur de plasma de façon à convertir une tension d'entrée, dont la fréquence est régulée selon le procédé, en une haute tension de sortie du côté entrée (1a), un plasma étant généré du côté sortie (1b) en raison de l'ionisation d'un gaz de travail circulant autour du générateur de plasma.

4. Circuit comprenant :
- un transformateur piézoélectrique (1) muni d'un côté entrée (1a) et d'un côté sortie (1b),
- une source de tension alternative (2) destinée à générer une tension d'entrée de fréquence prédéterminée du côté entrée (1a) du transformateur piézoélectrique (1),
- un dispositif de détection (4) qui est placé dans un chemin de rétroaction entre le côté d'entrée (1a) du transformateur piézoélectrique (1) et la source de tension alternative (2) pour détecter une information de phase de l'impédance d'entrée du transformateur piézoélectrique (1) et
- un dispositif de régulation (5) qui est conçu pour évaluer l'information de phase acquise quant à un critère de phase prédéterminé et pour spécifier une fréquence de la source de tension alternative (2) en fonction de l'information de phase évaluée afin de générer de la tension d'entrée,
- le dispositif de détection (4) comprenant un détecteur de phase,
- le détecteur de phase comprenant une porte XOR (7) et un filtre passe-bas (TP) qui sont montés en série, et
- un signal de signe de la tension d'entrée étant appliqué à une première entrée de la porte XOR (7) et un signal de signe proportionnel au courant d'entrée du côté entrée (1a) du transformateur piézoélectrique (1) étant appliqué à une deuxième entrée de la porte XOR (7) de façon à pouvoir générer à la sortie de la porte XOR (7) un signal de sortie comprenant l'information de phase de l'impédance d'entrée comme signal de comparaison qui est moyenné au moyen du filtre passe-bas (TP) pour former un signal proportionnel à la valeur de l'angle de phase de l'impédance d'entrée du transformateur piézoélectrique (1).

5. Circuit selon la revendication 4, le transformateur piézoélectrique (1) étant un générateur de plasma piézoélectrique qui est conçu pour générer une haute tension de sortie du côté sortie (1b) à partir de la tension d'entrée du côté entrée (1a) de façon à générer du côté sortie (1b) un plasma autour du gaz de travail en raison de l'ionisation du générateur de plasma.
